# EUROPEAN PATENT APPLICATION

(11) **EP 4 788 068 A1**
(43) Date of publication of application: **05.08.2026**
(21) Application number: 24869804.5
(22) Date of filing: 31.05.2024
(51) Int. Cl.: H05K 5/02

(54) **ELECTRONIC PRODUCT PROTECTIVE CASE AND SHEET THEREOF, AND METHOD FOR MANUFACTURING SHEET**

(30) Priority: 28.09.2023 CN 202311290516
(71) Applicant: Shenzhen Lingyi Innovation Technology Co., Ltd., Shenzhen Guangdong 518102 (CN)
(72) Inventor: ZHENG, Yanghui, Shenzhen, Guangdong 518000 (CN); LIU, Qiushun, Shenzhen, Guangdong 518000 (CN)
(74) Representative: Herrero & Asociados, S.L.
(86) International application number: PCT/CN2024/096515
(87) International publication number: WO 2025/066241

(57) **Abstract**

The present disclosure relates to an electronic product protective case and a sheet thereof, and a method for manufacturing the sheet. The sheet includes a sheet main body (11) with a thickness not greater than 0.9 mm. The sheet main body (11) includes a hot-melt matrix and reinforcing fibers contained within the hot-melt matrix; the sheet main body (11) is arranged with a receiving cavity and a sheet magnet (21) accommodated in the receiving cavity; the sheet main body (11) has a first filling part (113) that enters between the sheet magnet (21) and a cavity wall of the receiving cavity, a second filling part (114) covering a front side of the sheet magnet (21), and a third filling part (115) covering a back side of the sheet magnet; and the three filling parts are integrally connected to a part of the sheet main body (11) located outside the receiving cavity, forming an integrated one-piece whole, thereby embedding the sheet magnet (21) therein. The present disclosure may improve the reliability of the connection between the sheet magnet and the sheet main body, and reduce or eliminate the impact caused by the uneven thickness of the sheet magnet.

## Description

### TECHNICAL FIELD

The present disclosure relates to a sheet and a method for manufacturing the same, and more particularly, to a sheet with a magnetic attraction function, and a method for manufacturing such a sheet.

### BACKGROUND

With the development of magnetic charging technology, electronic product protective cases with magnetic attraction function have become popular. Regardless of whether the electronic product itself has a magnetic attraction module, as long as it has a wireless charging module, magnetic wireless charging can be achieved through a protective case with a magnetic attraction function. For protective cases of portable electronic products, such as a mobile phone case, users hope the case can be thin enough to provide a better grip. However, to obtain sufficient magnetic attraction force, the magnet in the mobile phone case must have a certain thickness, and sheet magnets are usually applied. When installing the sheet magnet into a groove inside the mobile phone case, if the thickness of the sheet magnet does not match the groove thickness of the mobile phone case well, convex marks or concave marks will be left on the local surface of the mobile phone case, which affects aesthetics. Especially when using multiple sheet magnets, the uniformity of thickness is more difficult to guarantee. In addition, the connection reliability between the multiple sheet magnets and the groove of the mobile phone case may be reduced. Therefore, a better improvement solution is urgently needed.

### SUMMARY OF THE DISCLOSURE

### Technical Problem

One purpose of the present disclosure is to improve the reliability of assembling sheet magnets in a sheet, and to reduce or eliminate the impact caused by uneven thickness of the sheet magnets.

### Technical Solution

To this end, a first aspect of the present disclosure provides a sheet, including a sheet main body, wherein a thickness of the sheet main body does not exceed 0.9 mm; the sheet main body includes a hot-melt matrix and reinforcing fibers contained in the hot-melt matrix; the sheet main body is arranged with a receiving cavity and a sheet magnet received in the receiving cavity, a thickness of the sheet magnet being less than the thickness of the sheet main body; the sheet main body includes a first filling part that enters between the sheet magnet and a cavity wall of the receiving cavity, a second filling part covering a front surface of the sheet magnet, and a third filling part covering a back surface of the sheet magnet; the first filling part connects the second filling part and the third filling part, and is connected to a part of the sheet main body located outside the receiving cavity to form an integrated one-piece whole, such that the sheet magnet is embedded in the receiving cavity.

In some embodiments, the front surface and the back surface of the sheet magnet are completely covered by the second filling part and the third filling part respectively, enabling the sheet main body to have a uniform thickness.

In some embodiments, the first filling part is formed by the hot-melt matrix of the sheet main body entering between the sheet magnet and the cavity wall of the receiving cavity, the first filling part being connected to the part of the sheet main body located outside the receiving cavity to form an integrated one-piece whole.

In some embodiments, the second filling part and the third filling part are formed by the hot-melt matrix of the sheet main body spreading along a surface of the sheet magnet when or after forming the first filling part.

In some embodiments, the receiving cavity receives a plurality of the sheet magnets, and the plurality of sheet magnets are arranged at intervals along a planar direction of the sheet main body; the sheet main body includes a fourth filling part that enters a gap between each two adjacent sheet magnets; the fourth filling part is connected to the first filling part, the second filling part, and the third filling part to form an integrated one-piece whole.

In some embodiments, the plurality of sheet magnets are arranged in a ring; the sheet main body further includes a central part surrounded by the plurality of sheet magnets; the central part is connected to the first filling part, the second filling part, the third filling part, and the fourth filling part to form an integrated one-piece whole.

In some embodiments, the thickness of each sheet magnet is 0.05~0.5 mm less than the thickness of the sheet main body.

In some embodiments, the sheet further includes: an inner shell, covering an inner side surface of the sheet main body and connected to the sheet main body to form an integrated one-piece whole; wherein the inner shell covers a position corresponding to the sheet magnet to strengthen a connection between the sheet magnet and the sheet main body.

In some embodiments, the sheet further includes: an outer shell, covering an outer side surface of the sheet main body and connected to the sheet main body to form an integrated one-piece whole; wherein the outer shell covers a position corresponding to the sheet magnet to strengthen a connection between the sheet magnet and the sheet main body.

A second aspect of the present disclosure provides an electronic product protective case applying the sheet defined in the first aspect of the present disclosure, at least a part of the protective case includes the sheet according to the first aspect of the present disclosure.

A third aspect of the present disclosure provides a method for manufacturing a sheet, including:
operation S101, impregnating a reinforcing fiber sheet with a hot-melt matrix to obtain a first sheet;
operation S103, defining a receiving cavity for receiving a sheet magnet on the first sheet; wherein the receiving cavity is a through hole penetrating a thickness direction of the first sheet or a blind groove not penetrating the thickness direction of the first sheet;
operation S105, assembling the sheet magnet into the receiving cavity; wherein a thickness of the sheet magnet is less than a thickness of the first sheet; and
operation S107, placing the first sheet and the sheet magnet assembled in the first sheet as a whole between two release films, and performing hot-press curing in a vacuum hot-press tank, for causing the hot-melt matrix of the first sheet in a molten state to flow between the sheet magnet and a cavity wall of the receiving cavity to form a first filling part, flow onto two surfaces of the sheet magnet to form a second filling part and a third filling part, and the sheet magnet to be embedded in the first filling part, the second filling part, and the third filling part, to obtain a sheet main body with a thickness not exceeding 0.9 mm.

In some embodiments, the method further includes operation S109, adding an outer shell and/or an inner shell to the sheet main body to form a one-piece sheet; wherein the inner shell covers an inner surface of the sheet main body by a coating process or a hot-press molding process, with a thickness of 0.05~0.15 mm or 10%~35% of the thickness of the sheet main body.

### Beneficial Effects

Implementing the present disclosure, the sheet main body has a first filling part between the sheet magnet and the cavity wall of the receiving cavity, a second filling part and a third filling part on the front surface and the back surface of the sheet magnet respectively, and the first filling part, the second filling part, and the third filling part are connected to a part of the sheet main body located outside the receiving cavity to form an integrated one-piece whole, which may improve the reliability of the connection between the sheet magnet and the sheet main body. When this sheet main body is applied to manufacture a mobile phone protective case, the present disclosure may reduce or eliminate the impact caused by uneven thickness of the sheet magnet, for example, the impact caused by uneven thickness between the sheet magnet and the magnet receiving cavity of the mobile phone protective case, or the impact caused by incomplete leveling.

### BRIEF DESCRIPTION OF THE DRAWINGS

To further reveal the specific technical content of the present disclosure, the following drawings are provided for reference.
FIG. 1 is a perspective schematic diagram of a mobile phone protective case according to the present disclosure viewed from a front direction.
FIG. 2 is a perspective schematic diagram of the mobile phone protective case shown in FIG. 1 viewed from a back direction.
FIG. 3 is a plan view schematic diagram of the mobile phone protective case shown in FIG. 1 viewed from the front direction.
FIG. 4 is a cross-sectional view taken along line A-A of the mobile phone protective case shown in FIG. 3.
FIG. 5 is a partial enlarged view of FIG. 4.
FIG. 6 is a plan view schematic diagram of the mobile phone protective case shown in FIG. 1 viewed from a side direction.
FIG. 7 is a cross-sectional view taken along line B-B of the mobile phone protective case shown in FIG. 6.
FIG. 8 is a partial enlarged view of FIG. 7.
FIG. 9 is a flowchart of a method for preparing a sheet main body according to the present disclosure.

### DETAILED DESCRIPTION

The technical solutions in the embodiments of the present disclosure will be described below in conjunction with the drawings of the present disclosure.

A sheet provided by some embodiments of the present disclosure is applied to a mobile phone protective case. Understandably, the use of the sheet is not limited to mobile phone protective cases.

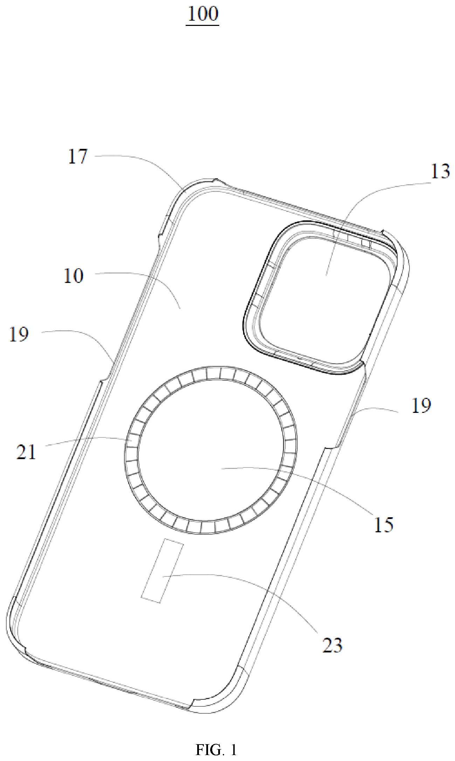

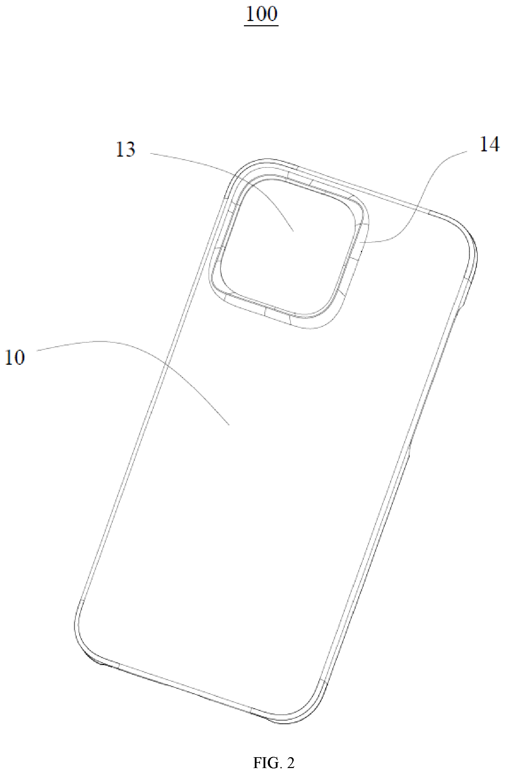

Referring to FIG. 1 and FIG. 2, the mobile phone protective case 100 includes a back plate 10 and a side plate 17 bent from an edge of the back plate 10. The back plate 10 is for attaching to a back of a mobile phone (not shown), and the side plate 17 is for encircling a side of the mobile phone, thereby installing the mobile phone into the mobile phone protective case 100. Preferably, the back plate 10 and the side plate 17 are an integrated one-piece structure. Understandably, the back plate 10 may define an avoidance through hole 13 to avoid a camera of the mobile phone. An outside of the avoidance through hole 13 may be arranged with an outward flange 14 to protect the exposed camera of the mobile phone. The side plate 17 may define an avoidance notch 19 to avoid a physical button of the mobile phone. It is understandable that the avoidance notch 19 may be in the form of a through hole.

The thickness of the back plate 10 does not exceed 2 mm, preferably, does not exceed 1.5 mm, to provide a better grip. The back plate 10 is fixedly arranged with a sheet magnet 21 to facilitate attraction to an external device such as a wireless charger. The thickness of the sheet magnet 21 is less than the thickness of the back plate 10. The back plate 10 may further be fixedly arranged with a magnetic force calibrator 23 to enhance magnetic positioning between the mobile phone protective case 100 and an external object such as a wireless charger.

In some embodiments, the back plate 10 is fixedly arranged with multiple sheet magnets 21. The multiple sheet magnets 21 are arranged at intervals along a planar direction of the back plate 10. More specifically, the multiple sheet magnets 21 may be arranged in a ring. The back plate 10 further includes a central part 15 surrounded by the multiple sheet magnets 21.

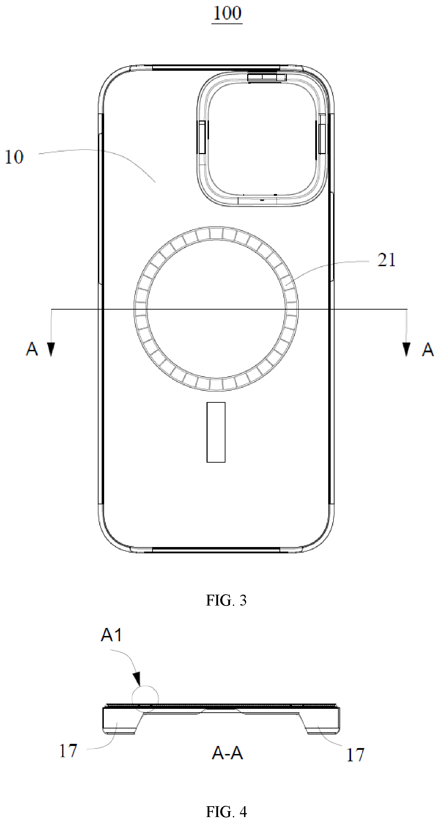

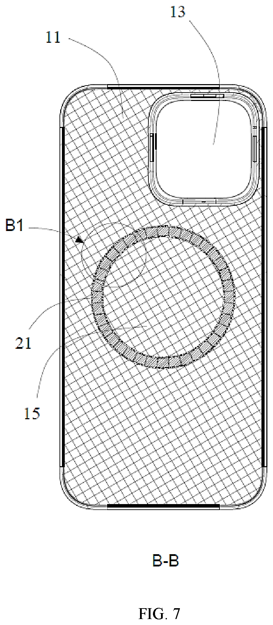

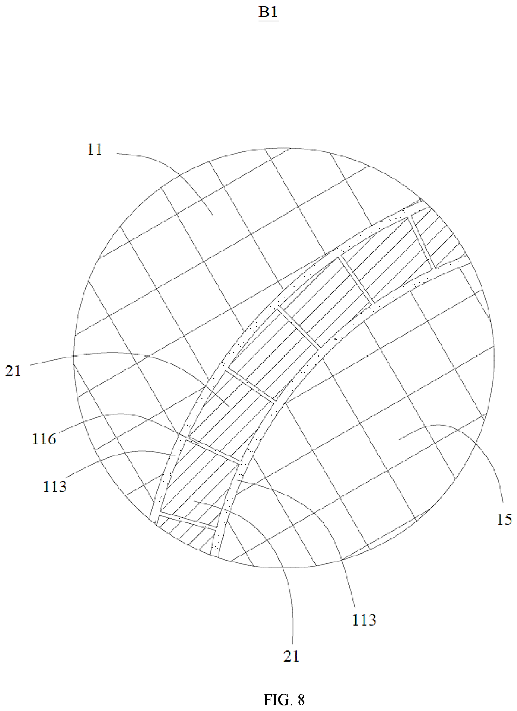

The back plate 10 may be made of a sheet, which will be described in more detail below with reference to FIG. 3 to FIG. 8.

Referring to FIG. 3 to FIG. 5, in some embodiments, the back plate 10 includes a sheet main body 11, an inner shell 118 attached to an inner wall of the sheet main body 11, and an outer shell 119 attached to an outer wall of the sheet main body 11. The sheet main body 11, the inner shell 118, and the outer shell 119 may form an integrated one-piece whole. The thickness of the sheet main body 11 does not exceed 0.9 mm. The material of the outer shell 119 may be plastic, metal, Kevlar material, etc. The material of the inner shell 118 is preferably polyester film (PC, PET, TPU, etc.), polyethylene film (PE, PTFE, etc.), polypropylene film, epoxy film, etc.

The sheet main body 11 may define a receiving cavity for receiving the sheet magnet(s) 21. Before assembling the sheet magnet 21, the receiving cavity may be a through hole penetrating the thickness direction of the sheet main body 11, or a blind groove recessed on a front or back surface of the sheet main body 11. The thickness of the sheet magnet 21 is less than the thickness of the sheet main body 11, for example, the difference in thickness is 0.05~0.5 mm. Understandably, the receiving cavity in the form of a through hole or a blind groove has a cavity wall. The sheet main body 11 has a first filling part 113 that enters a gap between the sheet magnet 21 and the cavity wall of the receiving cavity, a second filling part 114 covering a front surface of the sheet magnet 21, and a third filling part 115 covering a back surface of the sheet magnet 21. The sheet magnet 21 is closely surrounded by the corresponding first filling part 113, second filling part 114, and third filling part 115, and together they fill the receiving cavity. The first filling part 113 connects the second filling part 114 and the third filling part 115, and is connected to a part of the sheet main body 11 located outside the receiving cavity to form an integrated one-piece whole, and is further connected to the central part 15 of the sheet main body 11 located inside the receiving cavity to form an integrated one-piece whole, such that the sheet magnet 21 is embedded therein. This solution may not only improve the firmness and reliability of embedding the magnet 21 into the sheet main body 11, but also eliminate the negative impact caused by uneven thickness of the sheet magnet 21 itself and uneven thickness between the sheet magnet 21 and the sheet main body 11, thereby improving the thickness uniformity of the sheet main body 11. Preferably, the front surface and the back surface of the sheet magnet 21 are completely covered by the second filling part 114 and the third filling part 115 respectively, such that the sheet main body 11 has a uniform thickness, and the front and back surfaces of the sheet main body 11 remain flat, thereby avoiding convex or concave marks left by the sheet magnet on the local surface of the back plate 10 of the mobile phone protective case 100.

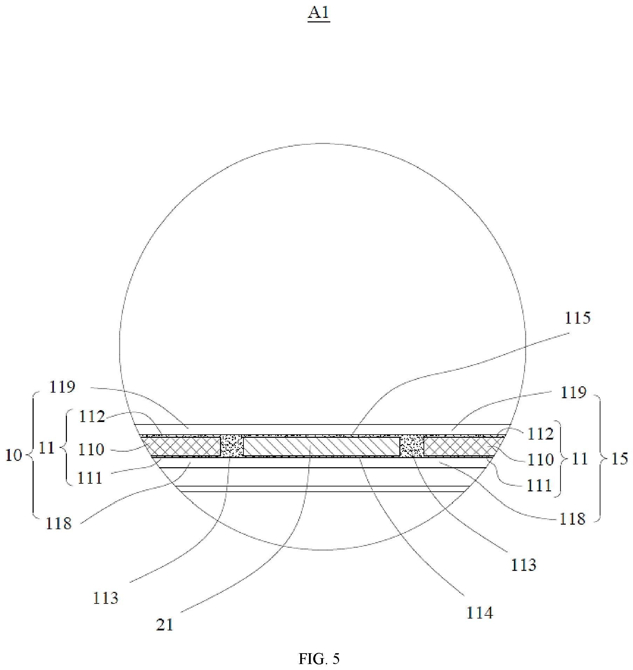

In some embodiments, before assembling the sheet magnet 21, the receiving cavity of the sheet main body 11 is in the form of a through hole. The sheet main body 11 includes a hot-melt matrix and reinforcing fibers contained in the hot-melt matrix. For example, the reinforcing fibers are glass fibers or aramid fibers, and the hot-melt matrix may be epoxy resin. After assembling the sheet magnet 21 into the receiving cavity of the sheet main body 11, the sheet main body 11 is heated and pressurized. As shown in FIG. 5, a part of the material of the sheet main body 11 (mainly the hot-melt matrix in a molten state) flows into the gap between the sheet magnet 21 and the cavity wall of the receiving cavity to form the first filling part 113. Understandably, the first filling part 113 is connected to the part of the sheet main body 11 located outside the receiving cavity to form an integrated one-piece whole. A part of the material of the sheet main body 11 (mainly the hot-melt matrix in a molten state) spreads along the surface of the sheet magnet 21 when or after forming the first filling part 113 to form the second filling part 114 and the third filling part 115, respectively. Thus, the second filling part 114 and the third filling part 115 are connected to the sheet main body 11 on both sides of the receiving cavity through the first filling part 113 to form an integrated one-piece whole.

In some embodiments, the sheet main body 11 is obtained by impregnating a glass fiber woven fabric with a hot-melt base material such as resin and then curing it. After curing, it exhibits an integrated and inseparable characteristic. The resin wraps the glass fiber woven fabric. FIG. 5 is a schematic illustration showing microscopic details, depicting the sheet main body 11 as three layers 110-112, where the middle layer 110 is the glass fiber woven fabric, and the inner sealing layer 111 and the outer sealing layer 112 are the cured resin, such as epoxy resin, PC resin, TPU resin, TPE resin, or other thermoplastic or thermosetting resins that meet the requirements. It should be noted that the physical layering of the sheet main body 11 of the present disclosure and the size ratio of each layer are not limited to the solution shown in FIG. 5. For example, the sheet main body 11 obtained by impregnating the glass fiber woven fabric with a hot-melt base material such as resin may not have obvious layer boundaries, or the physical dimensions of each layer may be different or not completely the same as shown in FIG. 5. Understandably, the first filling part 113, the second filling part 114, and the third filling part 115 may mainly be resin, so they can be connected to the sheet main body 11 on both sides of the receiving cavity to form an integrated one-piece whole.

Preferably, the inner shell 118 covers a position corresponding to the sheet magnet 21 to strengthen a connection between the sheet magnet 21 and the sheet main body 11. Understandably, the inner shell 118 may be in the form of a film, and its thickness is less than the thickness of the sheet main body 11. Similarly, the outer shell 119 at least covers a position corresponding to the sheet magnet 21 to strengthen a connection between the sheet magnet 21 and the sheet main body 11.

In other embodiments, the inner shell 118 and/or the outer shell 119 are omitted according to actual needs.

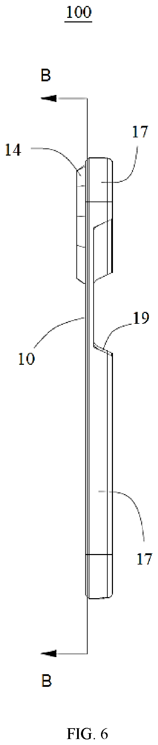

Referring to FIG. 6 to FIG. 8, the sheet main body 11 has a fourth filling part 116 that enters a gap between two adjacent sheet magnets 21. The fourth filling part 116 is connected to the first filling part 113, the second filling part 114, and the third filling part 115 to form an integrated one-piece whole. Thus, the periphery, front surface, and back surface of each sheet magnet 21 are wrapped and positioned.

The thickness of the sheet magnet 21 may be 0.25 ~0.4 mm, preferably 0.3 mm. The thickness of the sheet main body 11 may be 0.05~0.5 mm greater than that of the sheet magnet 21, preferably 0.15~0.35 mm greater; or 10%~40% greater than the thickness of the sheet magnet 21, more preferably 15%~35% greater. The outer shell 119 may be made of pre-impregnated aramid fiber material, with a thickness of 0.1~0.4 mm, preferably 0.25~0.35 mm, or 50%~150% of the thickness of the sheet main body 11. The inner shell 118 may be in the form of a laminated film, made of polyester film (PC, PET, TPU, etc.), polyethylene film (PE, PTFE, etc.), polypropylene film, epoxy film, etc. It covers the inner surface of the sheet main body 11 by a coating process or a hot-press molding process, with a thickness of 0.02-0.28 mm, more preferably 0.05~0.15 mm, or 10%~35% of the thickness of the sheet main body 11, more preferably 15%~30% of the thickness of the sheet main body 11.

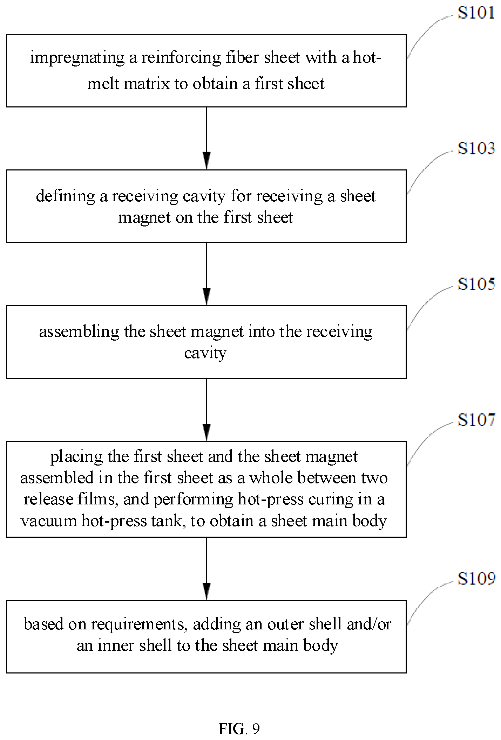

FIG. 9 is a flowchart of a method for preparing a sheet main body according to the present disclosure. As shown in FIG. 9, in operation S101, a reinforcing fiber sheet is impregnated with a hot-melt matrix to obtain a first sheet. Then, in operation S103, a receiving cavity for receiving a sheet magnet is defined on the first sheet. The receiving cavity may be a through hole penetrating a thickness direction of the first sheet, or a blind groove recessed from a front or back surface of the first sheet. Then, in operation S105, the sheet magnet is assembled into the receiving cavity, a thickness of the sheet magnet being less than a thickness of the first sheet. Then, in operation S107, the first sheet and the sheet magnet assembled in the first sheet are placed as a whole between two release films, and hot-press curing is performed in a vacuum hot-press tank, such that the hot-melt matrix in a molten state flows between the sheet magnet and the cavity wall of the receiving cavity to form a first filling part, flows onto a surface of the sheet magnet to form a second filling part and/or a third filling part, flows into the gaps between sheet magnets to obtain a fourth filling part, etc., thereby obtaining the sheet main body. Then, in operation S109, an outer shell and/or an inner shell are added to the sheet main body as needed. Preferably, the inner shell covers the inner surface of the sheet main body by a coating process or a hot-press molding process, with a thickness of 0.05~0.15 mm or 10%~35% of the thickness of the sheet main body, more preferably, the thickness of the inner shell is 15%~30% of the thickness of the sheet main body.

The above-described embodiments only express several implementation modes of the present disclosure, and the description thereof is relatively specific and detailed, but should not be construed as limiting the scope of the present disclosure. It should be pointed out that, for those skilled in the art, without departing from the concept of the present disclosure, several modifications and improvements may be made, and these all fall within the scope of the present disclosure. Therefore, the scope of the present disclosure shall be subject to the appended claims.

## Claims

1. A sheet, comprising a sheet main body (11); wherein a thickness of the sheet main body (11) does not exceed 0.9 mm; **characterized in that**, the sheet main body (11) comprises a hot-melt matrix and reinforcing fibers contained in the hot-melt matrix; the sheet main body (11) is arranged with a receiving cavity and a sheet magnet (21) received in the receiving cavity, a thickness of the sheet magnet (21) being less than the thickness of the sheet main body (11); the sheet main body (11) comprises a first filling part (113) that enters between the sheet magnet (21) and a cavity wall of the receiving cavity, a second filling part (114) covering a front surface of the sheet magnet (21), and a third filling part (115) covering a back surface of the sheet magnet (21); the first filling part (113) connects the second filling part (114) and the third filling part (115), and is connected to a part of the sheet main body (11) located outside the receiving cavity to form an integrated one-piece whole, such that the sheet magnet (21) is embedded in the receiving cavity.

2. The sheet according to claim 1, wherein the front surface and the back surface of the sheet magnet (21) are completely covered by the second filling part (114) and the third filling part (115) respectively, enabling the sheet main body (11) to have a uniform thickness.

3. The sheet according to claim 1, wherein the first filling part (113) is formed by the hot-melt matrix of the sheet main body (11) entering between the sheet magnet (21) and the cavity wall of the receiving cavity, the first filling part (113) being connected to the part of the sheet main body (11) located outside the receiving cavity to form an integrated one-piece whole; the second filling part (114) and the third filling part (115) are formed by the hot-melt matrix of the sheet main body (11) spreading along a surface of the sheet magnet (21) when or after forming the first filling part (113).

4. The sheet according to claim 1, wherein the receiving cavity receives a plurality of the sheet magnets (21), and the plurality of sheet magnets (21) are arranged at intervals along a planar direction of the sheet main body (11); the sheet main body (11) comprises a fourth filling part (116) that enters a gap between each two adjacent sheet magnets (21); the fourth filling part (116) is connected to the first filling part (113), the second filling part (114), and the third filling part (115) to form an integrated one-piece whole.

5. The sheet according to claim 4, wherein the plurality of sheet magnets (21) are arranged in a ring; the sheet main body (11) further comprises a central part (15) surrounded by the plurality of sheet magnets (21); the central part (15) is connected to the first filling part (113), the second filling part (114), the third filling part (115), and the fourth filling part (116) to form an integrated one-piece whole.

6. The sheet according to claim 1, wherein the thickness of each sheet magnet (21) is 0.05~0.5 mm less than the thickness of the sheet main body (11).

7. The sheet according to claim 1, further comprising:
an inner shell (118), covering an inner side surface of the sheet main body (11) and connected to the sheet main body (11) to form an integrated one-piece whole; wherein the inner shell (118) covers a position corresponding to the sheet magnet (21) to strengthen a connection between the sheet magnet (21) and the sheet main body (11); the inner shell covers an inner surface of the sheet main body by a coating process or a hot-press molding process, with a thickness of 0.05~0.15 mm or 10%~35% of a thickness of the sheet main body; and/or
an outer shell (119), covering an outer side surface of the sheet main body (11) and connected to the sheet main body (11) to form an integrated one-piece whole; wherein the outer shell (119) covers a position corresponding to the sheet magnet (21) to strengthen a connection between the sheet magnet (21) and the sheet main body (11).

8. An electronic product protective case, wherein at least a part of the electronic product protective case comprises the sheet according to claim 1.

9. A method for manufacturing a sheet, comprising:
operation S101, impregnating a reinforcing fiber sheet with a hot-melt matrix to obtain a first sheet;
operation S103, defining a receiving cavity for receiving a sheet magnet on the first sheet; wherein the receiving cavity is a through hole penetrating a thickness direction of the first sheet or a blind groove not penetrating the thickness direction of the first sheet;
operation S105, assembling the sheet magnet into the receiving cavity; wherein a thickness of the sheet magnet is less than a thickness of the first sheet; and
operation S107, placing the first sheet and the sheet magnet assembled in the first sheet as a whole between two release films, and performing hot-press curing in a vacuum hot-press tank, for causing the hot-melt matrix of the first sheet in a molten state to flow between the sheet magnet and a cavity wall of the receiving cavity to form a first filling part, flow onto two surfaces of the sheet magnet to form a second filling part and a third filling part, and the sheet magnet to be embedded in the first filling part, the second filling part, and the third filling part, to obtain a sheet main body with a thickness not exceeding 0.9 mm.

10. The method according to claim 9, further comprising:
operation S109, adding an outer shell and/or an inner shell to the sheet main body to form a one-piece sheet; wherein the inner shell covers an inner surface of the sheet main body by a coating process or a hot-press molding process, with a thickness of 0.05~0.15 mm or 10%~35% of the thickness of the sheet main body.
